# EUROPEAN PATENT SPECIFICATION

(11) **EP 4 050 978 B1**
(45) Date of publication and mention of the grant of the patent: **20.12.2023**
(21) Application number: 21218093.9
(22) Date of filing: 29.12.2021
(51) Int. Cl.: H05K 7/14, H02M 7/00, H02M 1/32, H02M 5/458, H02M 7/06, H02M 7/5387

(54) **POWER CONVERTER**
STROMWANDLER
CONVERTISSEUR DE PUISSANCE

(30) Priority: 25.02.2021 JP 2021029151
(43) Date of publication of application: 31.08.2022
(73) Proprietor: Fuji Electric Co., Ltd., Kawasaki-shi, Kanagawa 210-9530 (JP)
(72) Inventor: NAKATA, Toshiyuki, Kawasaki-shi, Kanagawa, 210-9530 (JP); TSUNAWAKI, Tomonori, Kawasaki-shi, Kanagawa, 210-9530 (JP); URUMA, Tomoki, Kawasaki-shi, Kanagawa, 210-9530 (JP)
(74) Representative: Appelt, Christian W.

(56) References cited:
- JP-A- 2020 171 153

## Description

### BACKGROUND OF THE INVENTION

### Field of the Invention

The present invention relates to a power converter, and more particularly, it relates to a power converter including a circuit board on which a power conversion semiconductor element is mounted, and a bus bar connected to the circuit board. Description of the Background Art

A circuit board unit including a circuit board on which a power conversion semiconductor element is mounted and a bus bar connected to the circuit board is known in general, as disclosed in Japanese Patent Laid-Open No. 2018-133302, for example.

A circuit board unit disclosed in Japanese Patent Laid-Open No. 2018-133302 includes a circuit board on which a power conversion semiconductor element is mounted and a bus bar connected to the circuit board. In this circuit board unit, a bus bar is fastened to a terminal pattern of the circuit board by bolts and nuts, and the bus bar and the circuit board are connected to each other. Furthermore, in the circuit board unit disclosed in Japanese Patent Laid-Open No. 2018-133302, an operator places the circuit board on a jig, and attaches the bus bar to the circuit board while making the jig hold the circuit board and the bus bar.

In the circuit board unit disclosed in Japanese Patent Laid-Open No. 2018-133302, the jig is used when the bus bar is attached to the circuit board, and thus when a product such as a power converter is assembled, it is necessary to temporarily attach the bus bar to the circuit board outside a housing, and then house the circuit board to which the bus bar has been attached in the housing. Therefore, workability during assembly of the product is decreased. On the other hand, although not clearly described in Japanese Patent Laid-Open No. 2018-133302, in a conventional circuit board unit as described in Japanese Patent Laid-Open No. 2018-133302, an operator needs to attach a bus bar to a circuit board while holding the circuit board and the bus bar by hand when attaching the bus bar to the circuit board in a housing without using a jig. Therefore, workability during attachment of the bus bar to the circuit board in the housing is decreased.

### SUMMARY OF THE INVENTION

The present invention has been proposed in order to solve the aforementioned problem, and an object of the present invention is to provide a power converter capable of significantly reducing or preventing a decrease in workability during attachment of a bus bar to a circuit board in a housing.

The invention is defined by the features of claim 1. Further embodiments are defined in the dependent claims.

### BRIEF DESCRIPTION OF THE DRAWINGS

FIG. 1 is a diagram showing an example of the circuit configuration of a power converter according to a first embodiment of the present invention;
FIG. 2 is an exploded perspective view for illustrating the configuration of the power converter according to the first embodiment;
FIG. 3 is a perspective view showing the configuration of a second bus bar according to the first embodiment;
FIG. 4 is a side view showing a connection between a first bus bar and the second bus bar according to the first embodiment;
FIG. 5 is a diagram showing a mount of a housing according to the first embodiment, as viewed from above;
FIG. 6 is a partially enlarged view of the mount of FIG. 5;
FIG. 7 is a perspective view showing the mount of the housing according to the first embodiment;
FIG. 8 is a partially enlarged view of the mount of FIG. 7;
FIG. 9 is a diagram showing the second bus bar placed on the mount according to the first embodiment;
FIG. 10 is a partially enlarged view of the second bus bar placed on the mount of FIG. 9;
FIG. 11 is a first perspective view showing an assembly procedure of the power converter according to the first embodiment;
FIG. 12 is a partially enlarged view of the mount of FIG. 11;
FIG. 13 is a second perspective view showing the assembly procedure of the power converter according to the first embodiment;
FIG. 14 is a partially enlarged view of the mount of FIG. 13;
FIG. 15 is a third perspective view showing the assembly procedure of the power converter according to the first embodiment;
FIG. 16 is a perspective view showing the configuration of a second bus bar according to a second embodiment;
FIG. 17 is a diagram showing the second bus bar according to the second embodiment placed on a mount; and
FIG. 18 is a partially enlarged view of the mount of FIG. 17.

### DESCRIPTION OF THE PREFERRED EMBODIMENTS

Embodiments of the present invention are hereinafter described with reference to the drawings.

### First Embodiment

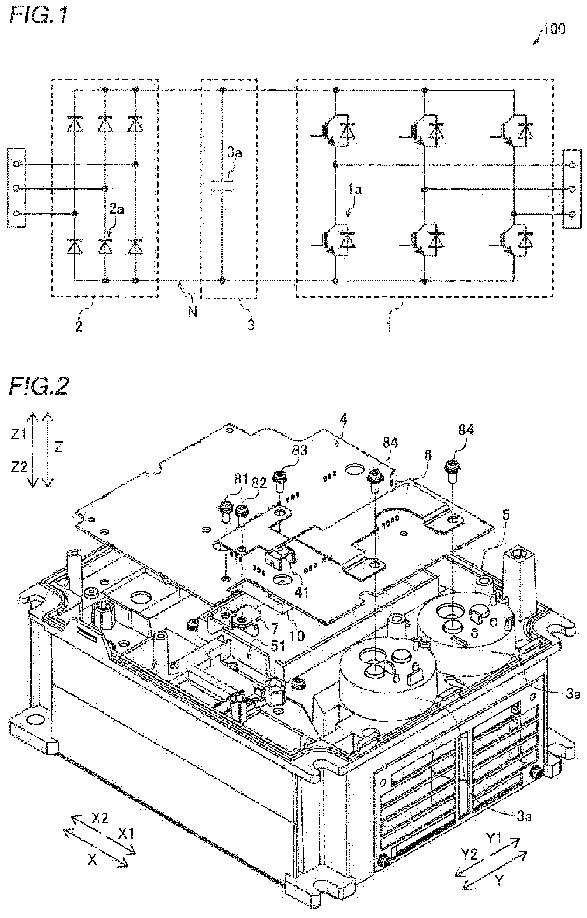

The overall configuration of a power converter 100 according to a first embodiment of the present invention is now described with reference to FIGS. 1 and 2. As shown in FIG. 1, the power converter 100 is an inverter including an inverter circuit 1 including switching elements 1a, a rectifier circuit 2 including diode elements 2a, and a smoothing circuit 3 including smoothing capacitors 3a. The switching elements 1a of the inverter circuit 1 and the diode elements 2a of the rectifier circuit 2 are electrically connected to the smoothing capacitors 3a of the smoothing circuit 3.

As shown in FIG. 2, the power converter 100 includes smoothing capacitors 3a, a circuit board 4, and a housing 5 that houses the smoothing capacitors 3a and the circuit board 4. Furthermore, the power converter 100 includes a first bus bar 6 connected to the smoothing capacitors 3a, and a second bus bar 7 connected to the circuit board 4 and connected to the smoothing capacitors 3a via the first bus bar 6.

In this description, an upward-downward direction is defined as a Z direction, a direction orthogonal to the upward-downward direction (Z direction) is defined as an X direction, and a direction orthogonal to the Z direction and the X direction is defined as a Y direction. The X direction is an example of a "second direction" in the claims, and the Y direction is an example of a "first direction" in the claims.

The first bus bar 6 and the second bus bar 7 are bus bars provided in a current path N (see FIG. 1) between the rectifier circuit 2 (diode elements 2a) and the smoothing circuit 3 (smoothing capacitors 3a). The first bus bar 6 and the second bus bar 7 are conductive plate-shaped members. For example, the first bus bar 6 and the second bus bar 7 are copper bars.

The circuit board 4 is a printed circuit board (PCB) on which a wiring pattern is formed by a conductor and electronic components are mounted. A semiconductor module 10 (see FIG. 2) including power conversion semiconductor elements (the switching elements 1a and the diode elements 2a) is mounted on the circuit board 4. That is, the power conversion semiconductor elements are mounted on the circuit board 4. The circuit board 4 extends along the X direction and the Y direction (XY plane). The XY plane is an example of a "horizontal plane" in the claims. The semiconductor module 10 is attached to the rear surface side (Z2 direction side) of the circuit board 4. As shown in FIG. 2, a connection terminal 41 is provided on the circuit board 4 to electrically connect the first bus bar 6 to the wiring pattern of the circuit board 4.

The housing 5 includes a mount 51 (see FIG. 2) to place the second bus bar 7. The housing 5 is made of a plastic resin. The detailed configuration of the housing 5 is described below.

### Configuration of Second Bus Bar

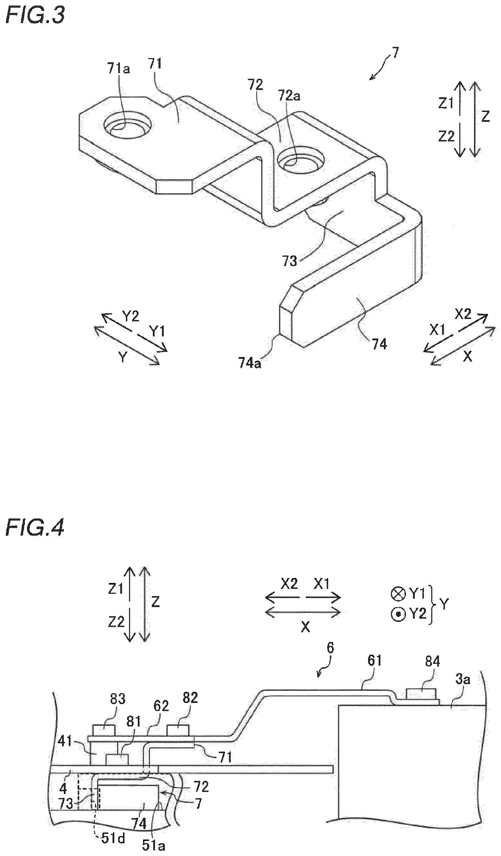

As shown in FIG. 3, the second bus bar 7 has a stepped shape including an upper portion 71 and a lower portion 72. The upper portion 71 of the second bus bar 7 integrally includes a nut 71a to screw the upper portion 71 to the first bus bar 6. The lower portion 72 of the second bus bar 7 integrally includes a nut 72a to screw the lower portion 72 to the circuit board 4.

As shown in FIG. 3, the second bus bar 7 includes the first leg 73 and a second leg 74. The first leg 73 and the second leg 74 are provided on the lower portion 72 side (Z2 direction side) of the second bus bar 7.

The first leg 73 extends downward (Z2 direction side) from the lower portion 72. The second leg 74 extends from the first leg 73 in a direction (X1 direction) orthogonal to the first leg 73. Furthermore, the second leg 74 extends in the X1 direction from an end of the first leg 73 on the Y1 direction side.

As shown in FIG. 4, the first bus bar 6 has a stepped shape including an upper portion 61 and a lower portion 62. The upper portion 61 and the lower portion 62 of the first bus bar 6 are arranged above (Z1 direction side) the upper portion 71 of the second bus bar 7. Furthermore, the upper portion 61 and the lower portion 62 of the first bus bar 6 are arranged above the circuit board 4 (connection terminal 41). Moreover, the upper portion 61 of the first bus bar 6 is arranged above the smoothing capacitors 3a.

As shown in FIG. 4, the upper portion 71 of the second bus bar 7 is arranged above (Z1 direction side) the circuit board 4. The lower portion 72 of the second bus bar 7 is arranged below (Z2 direction side) the circuit board 4. The first leg 73 and the second leg 74 are also arranged below the circuit board 4.

The first bus bar 6 is attached to the upper portion 71 of the second bus bar 7, and the circuit board 4 is attached to the lower portion 72 of the second bus bar 7.

On the upper side (Z1 direction side) of the upper portion 71 of the second bus bar 7, the lower portion 62 of the first bus bar 6 is screwed (fastened) from above by a screw 82 and the nut 71a (see FIG. 3), as shown in FIG. 4. On the upper side of the lower portion 72 of the second bus bar 7, the circuit board 4 is screwed (fastened) from above by a screw 81 and the nut 72a (see FIG. 3), as shown in FIG. 4. Thus, the second bus bar 7 is connected to a terminal pattern (not shown) provided on the circuit board 4, and the first bus bar 6 and the second bus bar 7 are electrically connected to the rectifier circuit 2 (see FIG. 1).

As shown in FIG. 4, the lower portion 62 of the first bus bar 6 is screwed (fastened) from above to the connection terminal 41 provided on the upper side (Z1 direction side) of the circuit board 4 by a screw 83. Furthermore, as shown in FIG. 4, the upper portion 61 of the first bus bar 6 is screwed (fastened) to the smoothing capacitors 3a from above by a screw 84.

### Configuration of Mount

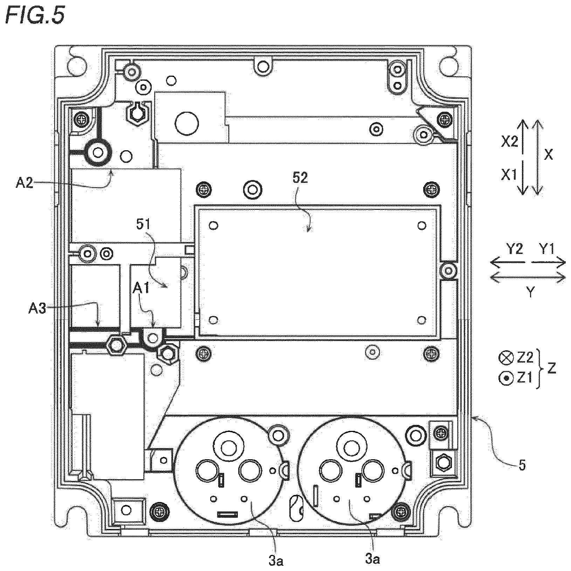

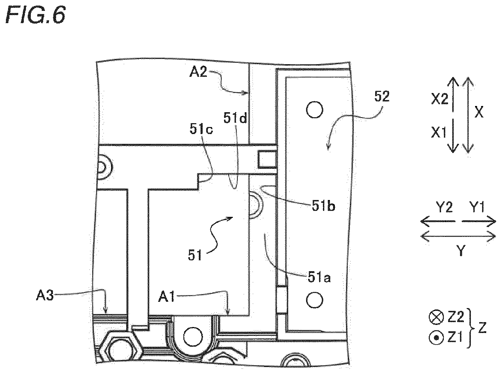

As shown in FIGS. 5 and 6, the housing 5 includes a module container 52 in which the semiconductor module 10 is housed (fitted). The mount 51 is arranged adjacent to the module container 52. The mount 51 is arranged on the Y2 direction side of the module container 52. The mount 51 and the module container 52 are integrally formed in the housing 5.

As shown in FIGS. 5 and 6, openings A1, A2, and A3 are provided in the housing 5. The openings A1 to A3 are openings for exposing a terminal of an electronic component (such as an EMC filter) attached from the lower side (Z2 direction side) of the housing 5 when the electronic component such as an EMC filter is provided (added) in the current path N (see FIG. 1).

As shown in FIG. 6, the mount 51 includes a bottom 51a on which the second bus bar 7 is placed, and a first standing wall 51b and a second standing wall 51c that face each other so as to sandwich the bottom 51a therebetween.

As shown in FIG. 6, the bottom 51a has a rectangular shape as viewed from above (Z1 direction side). The opening A1 is provided on the Y2 direction side of the bottom 51a. The first standing wall 51b is provided on the Y1 direction side of the bottom 51a.

As shown in FIG. 6, the mount 51 of the housing 5 includes a third standing wall 51d provided along the Y direction in which the first standing wall 51b and the second standing wall 51c face each other.

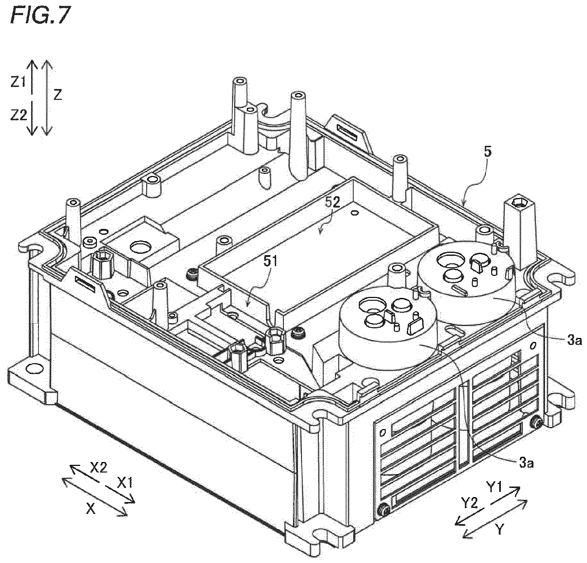

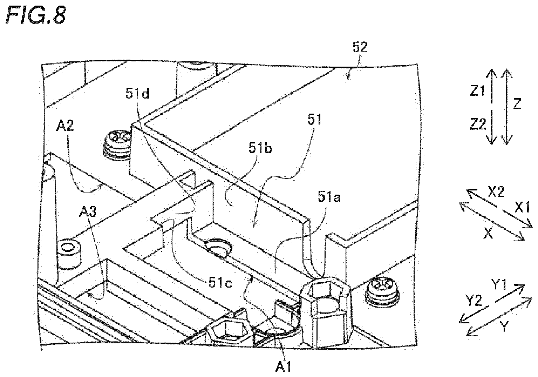

As shown in FIG. 6, the third standing wall 51d is arranged between the first standing wall 51b and the second standing wall 51c, and is provided so as to connect the first standing wall 51b to the second standing wall 51c. The bottom 51a is surrounded by the first standing wall 51b, the second standing wall 51c, and the third standing wall 51d (see FIG. 6). The first standing wall 51b and the third standing wall 51d of the mount 51 (see FIG. 7) extend in the Z1 direction from the bottom 51a (see FIG. 8). The second standing wall 51c extends in the Z direction along (substantially parallel to) the first standing wall 51b (see FIG. 8).

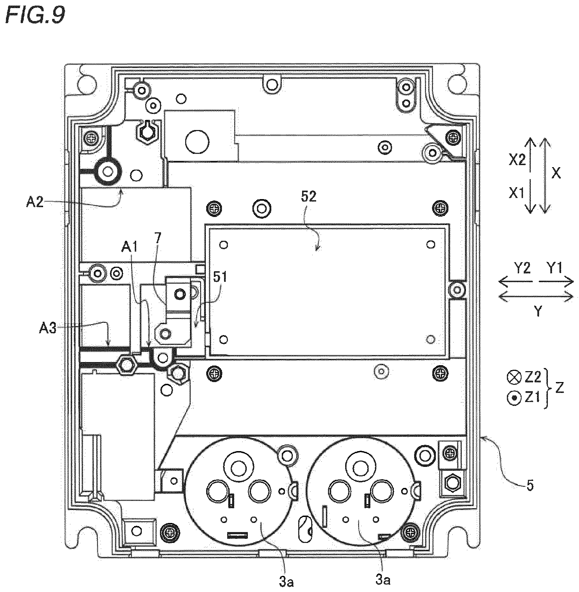

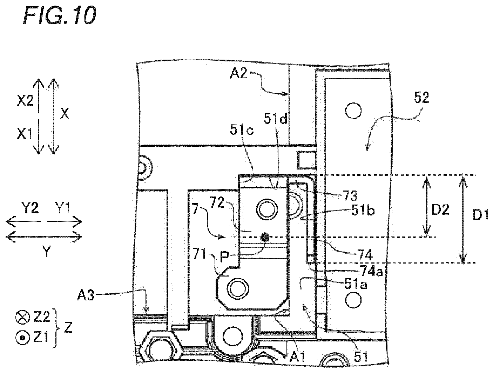

While the second bus bar 7 is placed on the mount 51 (bottom 51a) (see FIGS. 9 and 10), the first leg 73 extends in the Y1 direction along the third standing wall 51d (see FIG. 10). As shown in FIG. 10, while the second bus bar 7 is placed on the mount 51 (bottom 51a), the first standing wall 51b is arranged on the Y1 direction side of the first leg 73, and the second standing wall 51c is arranged on the Y2 direction side of the first leg 73. Furthermore, while the second bus bar 7 is placed on the mount 51 (bottom 51a), the third standing wall 51d is arranged on the X2 direction side of the first leg 73. A gap is provided in the order of several tenth of one millimeter between the first leg 73 and both the first standing wall 51b and the second standing wall 51c.

As shown in FIG. 10, the first leg 73 prevents the second bus bar 7 from tipping over to the Y1 direction side and the Y2 direction side in the Y direction in which the first standing wall 51b and the second standing wall 51c face each other by being fitted in between the first standing wall 51b and the second standing wall 51c of the mount 51. The Y1 direction side is an example of a "a first side in a first direction" in the claim, and the Y2 direction side is an example of a "second side in a first direction" in the claim.

As shown in FIG. 10, the first leg 73 is configured to prevent the second bus bar 7 from tipping over to the X2 direction side by coming into contact with the third standing wall 51d. The X2 direction side is an example of a "second side in a second direction" in the claims.

The second leg 74 (linearly) extends in the X1 direction along the first standing wall 51b (see FIG. 10). Furthermore, the second leg 74 extends in the X1 direction from the first leg 73 along the bottom 51a (see FIGS. 10 to 12).

The second leg 74 is configured to prevent the second bus bar 7 from tipping over to the X1 direction side in the X direction by coming into contact with the bottom 51a. The X1 direction side is an example of a "first side in a second direction" in the claims.

As shown in FIG. 10, the second leg 74 extends to the side (X1 direction side) opposite to the side on which the third standing wall 51d of the mount 51 is arranged in a direction (X direction) along the bottom 51a such that a distance D1 from the third standing wall 51d of the mount 51 to an end 74a of the second leg 74 is larger (longer) than a distance D2 from the third standing wall 51d of the mount 51 to a position P of the center of gravity of the second bus bar 7.

### Assembly Procedure

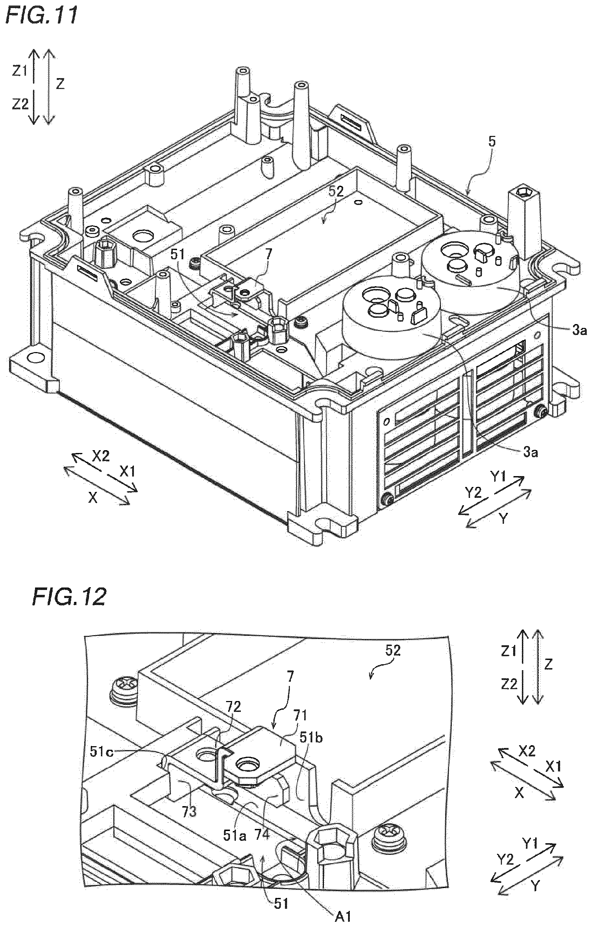

The operation of assembling the power converter 100 including the second bus bar 7 is now described with reference to FIGS. 11 to 15. First, an operator places the second bus bar 7 on the mount 51, as shown in FIGS. 11 and 12. Specifically, as shown in FIG. 12, the operator fits the first leg 73 of the second bus bar 7 in between the first standing wall 51b and the second standing wall 51c, and places the second leg 74 on the bottom 51a.

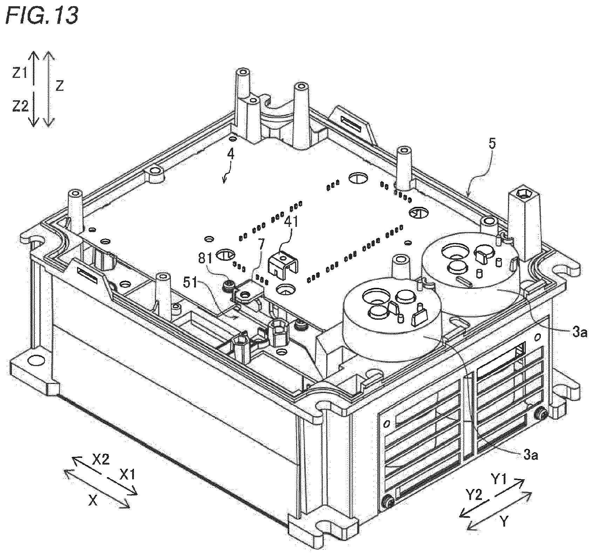

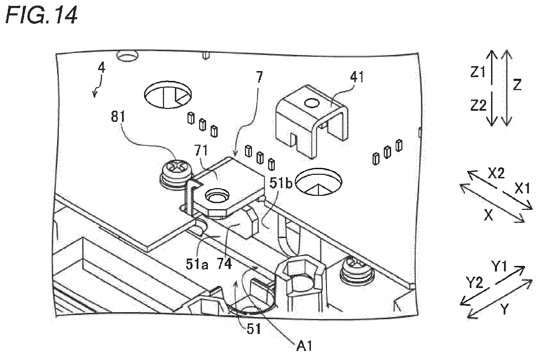

Next, as shown in FIGS. 13 and 14, the operator screws (fastens) the second bus bar 7 to the circuit board 4. Specifically, the operator places the circuit board 4 above (Z1 direction side) the lower portion 72 (see FIG. 12) of the second bus bar 7, and screws (fastens) the second bus bar 7 to the circuit board 4 from above by the screw 81, as shown in FIG. 14.

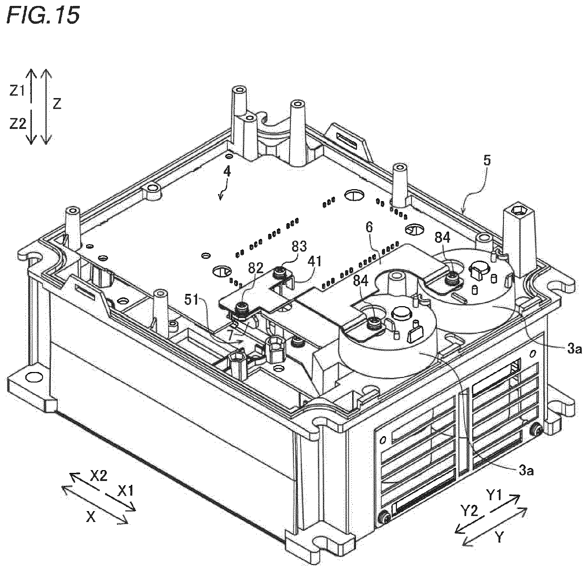

Then, the operator attaches the first bus bar 6, as shown in FIG. 15. Specifically, the first bus bar 6 is placed above (Z1 direction side) the upper portion 71 of the second bus bar 7, and the first bus bar 6 is screwed (fastened) to the second bus bar 7, the terminal 41 and the smoothing capacitors 3a from above by the screws 82, 83, and 84, respectively. In this manner, the first bus bar 6 and the second bus bar 7 are attached such that the wiring pattern (conductor pattern) of the circuit board 4 and the smoothing capacitors 3a are electrically connected to each other.

### Advantageous Effects of First Embodiment

According to the first embodiment, the following advantageous effects are achieved.

According to the first embodiment, the first leg 73 of the second bus bar 7 prevents the second bus bar 7 from tipping over to the Y1 direction side and the Y2 direction side by being fitted in between the first standing wall 51b and the second standing wall 51c of the mount 51. Furthermore, the second leg 74 of the second bus bar 7 prevents the second bus bar 7 from tipping over to the X1 direction side by coming into contact with the bottom 51a. Accordingly, when the second bus bar 7 is attached to the circuit board 4, the second bus bar 7 can be prevented from tipping over to three sides including the Y1 direction side, the Y2 direction side, and the X1 direction side. Consequently, the operator can easily attach the second bus bar 7 to the circuit board 4 in the housing 5 without holding the second bus bar 7, and thus a decrease in workability during attachment of the second bus bar 7 to the circuit board 4 in the housing 5 can be significantly reduced or prevented. Furthermore, with the configuration described above, the first leg 73 of the second bus bar 7 is fitted in between the first standing wall 51b and the second standing wall 51c of the mount 51, and thus the second bus bar 7 can be positioned with respect to the housing 5. Moreover, the circuit board 4 on which the semiconductor module 10 has been mounted is housed in the housing 5, and is attached to the second bus bar 7 such that when the first bus bar 6 is attached to the second bus bar 7, the second bus bar 7 can be prevented from tipping over. Thus, the operator can attach (screw-fasten) the first bus bar 6 connected to the smoothing capacitors 3a to the second bus bar 7 while the second bus bar 7 is stable. Consequently, as compared with a case in which the first bus bar 6 is attached (screw-fastened) to the second bus bar 7 while the second bus bar 7 is unstable, the first bus bar 6 can be reliably attached (screw-fastened) to the second bus bar 7. Thus, a decrease in quality due to improper attachment (improper screw-fastening) at the time of attaching (screw-fastening) the first bus bar 6 to the second bus bar 7 can be prevented. Consequently, a decrease in quality due to improper attachment (improper screw-fastening) at the time of attaching the first bus bar 6 connected to the smoothing capacitors 3a to the second bus bar 7 attached to the circuit board 4 can be prevented.

According to the first embodiment, as described above, the mount 51 of the housing 5 includes the third standing wall 51d provided along the Y direction. Furthermore, the first leg 73 is configured to prevent the second bus bar 7 from tipping over to the X2 direction side by coming into contact with the third standing wall 51d. Accordingly, when the second bus bar 7 is attached to the circuit board 4, the second bus bar 7 can be prevented from tipping over to four sides including the Y1 direction side, the Y2 direction side, the X1 direction side, and the X2 direction side. Consequently, the operator can more easily attach the second bus bar 7 to the circuit board 4 in the housing 5 without holding the second bus bar 7, and thus a decrease in workability during attachment of the second bus bar 7 to the circuit board 7 in the housing 5 can be further significantly reduced or prevented. Furthermore, with the configuration described above, the first leg 73 of the second bus bar 7 is fitted in between the first standing wall 51b and the second standing wall 51c of the mount 51, and the first leg 73 comes into contact with the third standing wall 51d such that the second bus bar 7 can be positioned with respect to the housing 5 in three directions of the Y1 direction, the Y2 direction, and the X2 direction. Furthermore, the circuit board 4 on which the semiconductor module 10 has been mounted is housed in the housing 5, and is attached to the second bus bar 7 such that when the first bus bar 6 is attached to the second bus bar 7, the second bus bar 7 can be prevented from tipping over. Accordingly, the operator can attach (screw-fasten) the first bus bar 6 connected to the smoothing capacitors 3a to the second bus bar 7 while the second bus bar 7 is more stable. Consequently, as compared with a case in which the first bus bar 6 is attached (screw-fastened) to the second bus bar 7 while the second bus bar 7 is unstable, the first bus bar 6 can be more reliably attached (screw-fastened) to the second bus bar 7. Thus, a decrease in quality due to improper attachment (improper screw-fastening) at the time of attaching (screw-fastening) the first bus bar 6 to the second bus bar 7 can be further prevented. Consequently, a decrease in quality due to improper attachment (improper screw-fastening) at the time of attaching the first bus bar 6 connected to the smoothing capacitors 3a to the second bus bar 7 attached to the circuit board 4 can be further prevented.

According to the first embodiment, as described above, the second leg 74 extends to the side (X1 direction side) opposite to the side on which the third standing wall 51d of the mount 51 is arranged in the direction (X direction) along the bottom 51a such that the distance D1 from the third standing wall 51d of the mount 51 to the end 74a of the second leg 74 is larger than the distance D2 from the third standing wall 51d of the mount 51 to the position P of the center of gravity of the second bus bar 7. Accordingly, the end 74a of the second leg 74 can be brought into contact with the bottom 51a of the mount 51 at a position spaced farther apart from the first leg 73 of the mount 51 than the position P of the center of gravity of the second bus bar 7, and thus the second bus bar 7 can be more stably placed on the mount 51 (bottom 51a). Consequently, the second bus bar 7 can be further prevented from tipping over.

According to the first embodiment, as described above, the first bus bar 6 is attached to the upper portion 71 of the second bus bar 7, and the circuit board 4 is attached to the lower portion 72 of the second bus bar 7. Furthermore, the first leg 73 and the second leg 74 are provided on the lower portion 72 side (Z2 direction side) of the second bus bar 7. Accordingly, the first leg 73 and the second leg 74 provided on the lower portion 72 side of the second bus bar 7 can prevent the second bus bar 7 from tipping over when the circuit board 4 on which the semiconductor module 10 has been mounted is attached to the lower portion 72 side of the second bus bar 7. Furthermore, the circuit board 4 on which the semiconductor module 10 has been mounted is housed in the housing 5, and is attached to the lower portion 72 of the second bus bar 7 such that when the first bus bar 6 is attached to the upper portion 71 of the second bus bar 7, the first bus bar 6 can be attached to the upper portion 71 of the second bus bar 7 while the second bus bar 7 is prevented from tipping over. Consequently, even when the first bus bar 6 is arranged above (Z1 direction side) the circuit board 4, the first bus bar 6 can be easily attached to the second bus bar 7.

According to the first embodiment, as described above, the lower portion 72 of the second bus bar 7 is arranged below (Z2 direction side) the circuit board 4, and integrally includes the nut 72a to screw the lower portion 72 to the circuit board 4. Accordingly, the lower portion 72 of the second bus bar 7 can be screwed to the circuit board 4 by the nut 72a of the lower portion 72. Consequently, even when the second bus bar 7 is screwed from the upper side (Z1 direction side) of the circuit board 4, it is not necessary for the operator to hold a nut provided separately from the second bus bar 7 below the second bus bar 7, and thus the lower portion 72 of the second bus bar 7 can be more easily attached (screwed) to the circuit board 4.

According to the first embodiment, as described above, the first leg 73 extends downward (Z1 direction side) from the lower portion 72, and the second leg 74 extends from the first leg 73 along the bottom 51a. Accordingly, the second leg 74 of the second bus bar 7 can come into contact with the bottom 51a of the mount 51 in a wider area by extending along the bottom 51a from the first leg 73 that extends downward from the lower portion 72. Consequently, the second bus bar 7 can be more stably placed on the mount 51 (bottom 51a).

According to the first embodiment, as described above, the second leg 74 extends in the direction along the bottom 51a and orthogonal to the first leg 73. Accordingly, the second bus bar 7 can be prevented from tipping over in the direction (X direction) orthogonal to the first leg 73.

### Second Embodiment

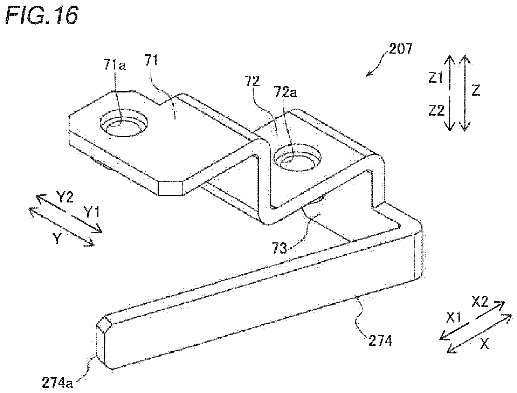

The configuration of a second bus bar 207 and a mount 251 according to a second embodiment of the present invention is now described with reference to FIGS. 16 to 18. The same configurations as those of the second embodiment are denoted by the same reference numerals, and description thereof is omitted.

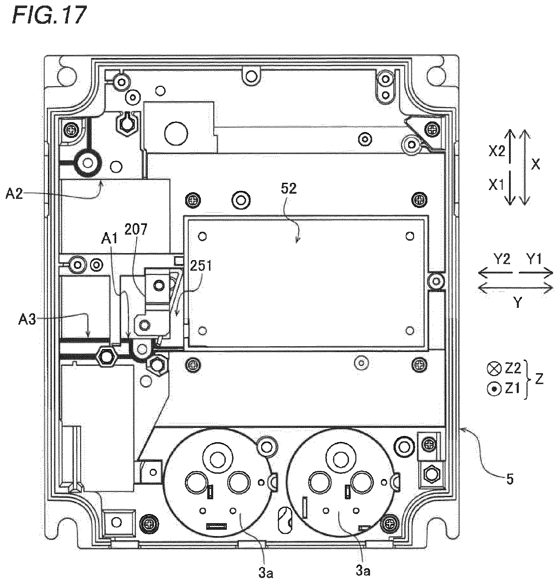

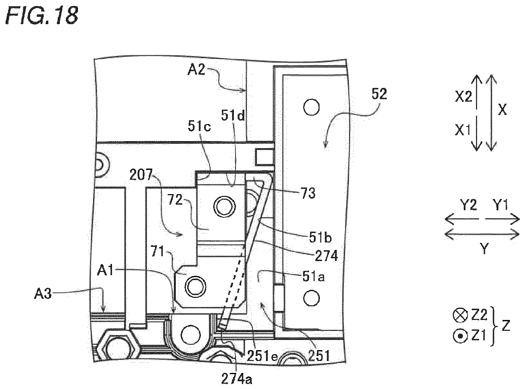

The second bus bar 207 includes a second leg 274 (see FIG. 16) that (linearly) extends from a first leg 73. As shown in FIG. 18, the mount 251 (see FIGS. 17 and 18) of a housing 5 includes a fourth standing wall 251e in addition to a bottom 51a, a first standing wall 51b, a second standing wall 51c, and a third standing wall 51d. The fourth standing wall 251e is provided in the vicinity of an end 274a (in the vicinity of a tip end) of the second leg 274, and comes into contact with the end 274a of the second leg 274 when the second bus bar 207 is fastened to a circuit board 4. Furthermore, the fourth standing wall 251e is provided on the side (X1 direction side) opposite to the side on which the third standing wall 51d is arranged with respect to the second bus bar 207.

The second leg 274 (linearly) extends along the bottom 51a, and (linearly) extends from the first leg 73 toward the fourth standing wall 251e (see FIG. 18). Furthermore, the second leg 274 is spaced farther apart from the first standing wall 51b toward the fourth standing wall 251e (X1 direction side). That is, the second leg 274 extends obliquely from the first leg 73.

The remaining configurations of the second embodiment are similar to those of the first embodiment.

### Advantageous Effects of Second Embodiment

According to the second embodiment, the following advantageous effects are achieved.

According to the second embodiment, similarly to the first embodiment, a decrease in workability during attachment of the second bus bar 207 to the circuit board 4 in the housing 5 can be significantly reduced or prevented.

According to the second embodiment, as described above, the mount 51 of the housing 5 includes the fourth standing wall 251e provided in the vicinity of the end 274a of the second leg 274, and comes into contact with the end 274a of the second leg 274 when the second bus bar 207 is fastened to the circuit board 4. Furthermore, the second leg 274 extends along the bottom 51a and extends from the first leg 73 toward the fourth standing wall 251e. Thus, when the second bus bar 207 is fastened to the circuit board 4, the end 274a of the second leg 274 comes into contact with the fourth standing wall 251e of the mount 251 such that displacement of the second bus bar 207 with respect to the circuit board 4 (see FIG. 2) due to a rotation torque can be significantly reduced or prevented. Consequently, a lower portion 72 of the second bus bar 207 can be more easily fastened to the circuit board 4.

The remaining advantageous effects of the second embodiment are similar to those of the first embodiment.

### Modified Examples

The embodiments disclosed this time must be considered as illustrative in all points and not restrictive. The scope of the present invention is not shown by the above description of the embodiments but by the scope of claims for patent, and all modifications (modified examples) within the meaning and scope of the scope of claims for patent are further included.

For example, while the mount 51 (mount 251) of the housing 5 includes the third standing wall 51d provided along the Y direction in addition to the bottom 51a, the first standing wall 51b, and the second standing wall 51c, and tipping over of the second bus bar 7 (second bus bar 207) to the four sides including the Y1 direction side (the first side in the first direction), the Y2 direction side (the second side in the first direction), the X1 direction side (the first side in the second direction), and the X2 direction side (the second side in the second direction) is prevented by the first leg 73 and the second leg 74 (second leg 274) of the second bus bar 7 (second bus bar 207) in each of the aforementioned first and second embodiments, the present invention is not restricted to this. For example, tipping over of the second bus bar only to three sides including the first side in the first direction, the second side in the first direction, and the first side in the second direction may alternatively be prevented by the first leg and the second leg of the second bus bar.

While only one second leg 74 (second leg 274) is provided in each of the aforementioned first and second embodiments, the present invention is not restricted to this. In the present invention, a plurality of (two or more) second legs may alternatively be provided.

While the second leg 74 (second leg 274) extends from the Y1 direction side (the first side in the first direction) of the first leg 73 to the X1 direction side (the first side in the second direction) in each of the aforementioned first and second embodiments, the present invention is not restricted to this. In the present invention, the second leg may alternatively extend from the end of the first leg on the second side (Y2 direction side) in the first direction to the first side (X1 direction side) in the second direction. In this case, the bottom of the mount is provided also on the second side in the first direction.

While the second bus bar 7 has a stepped shape including the upper portion 71 and the lower portion 72, the first bus bar 6 is attached to the upper portion 71 of the second bus bar 7, and the circuit board 4 is attached to the lower portion 72 of the second bus bar 7 in the aforementioned first embodiment, the present invention is not restricted to this. In the present invention, both the first bus bar and the circuit board may alternatively be attached to either the upper portion or the lower portion of the second bus bar. That is, the first bus bar and the circuit board may be attached to the second bus bar at substantially the same height. Alternatively, the second bus bar may not have a stepped shape, and both the first bus bar and the circuit board may be attached to the second bus bar.

While the lower portion 72 of the second bus bar 7 (second bus bar 207) is arranged below (Z2 direction side) the circuit board 4, and integrally includes the nut 72a to screw the lower portion 72 to the circuit board 4 in each of the aforementioned first and second embodiments, the present invention is not restricted to this. In the present invention, a nut may alternatively be provided separately from the second bus bar to screw the second bus bar.

While the second leg 74 (second leg 274) extends from the first leg 73 along the bottom 51a in each of the aforementioned first and second embodiments, the present invention is not restricted to this. In the present invention, the second leg may alternatively extend from the upper portion.

## Claims

1. A power converter (100) comprising:
a circuit board (4) configured to allow a power conversion semiconductor element to be mounted thereon;
a smoothing capacitor (3a);
a housing (5) configured to house the circuit board and the smoothing capacitor;
a first bus bar (6) connected to the smoothing capacitor; wherein the power converter (100) is **characterized by** further comprising
the first bus bar (6) above the circuit board (4) and the smoothing capacitor (3a),
a second bus bar (7, 207) connected to the circuit board, the second bus bar being connected to the smoothing capacitor via the first bus bar, wherein a portion of the second bus bar is arranged below the circuit board;
the housing includes a mount (51, 251) including a bottom (51a) configured to allow the second bus bar to be mounted thereon, and a first standing wall (51b) and a second standing wall (51c), both of which face each other so as to sandwich the bottom therebetween; and
the second bus bar includes a first leg (73) configured to prevent the second bus bar from tipping over to a first side and a second side in a first direction in which the first standing wall and the second standing wall face each other by being fitted in between the first standing wall and the second standing wall of the mount, and a second leg (74, 274) configured to prevent the second bus bar from tipping over to a first side in a second direction orthogonal to the first direction in a horizontal plane by coming into contact with the bottom.

2. The power converter according to claim 1, wherein
the mount of the housing includes a third standing wall (51d) provided along the first direction in which the first standing wall and the second standing wall face each other; and
the first leg is configured to prevent the second bus bar from tipping over to a second side in the second direction by coming into contact with the third standing wall.

3. The power converter according to claim 2, wherein the second leg is configured to extend to a side opposite to a side on which the third standing wall of the mount is arranged in a direction along the bottom such that a distance (D1) from the third standing wall of the mount to an end (74a, 274a) of the second leg is larger than a distance (D2) from the third standing wall of the mount to a position (P) of a center of gravity of the second bus bar.

4. The power converter according to any one of claims 1 to 3, wherein
the second bus bar has a stepped shape including an upper portion (71) and a lower portion (72);
the first bus bar is attached to the upper portion of the second bus bar;
the circuit board is attached to the lower portion of the second bus bar; and
the first leg and the second leg are provided on the lower portion side of the second bus bar.

5. The power converter according to claim 4, wherein the lower portion of the second bus bar is arranged below the circuit board, and integrally includes a nut (72a) to screw the lower portion to the circuit board.

6. The power converter according to claim 4 or 5, wherein
the first leg is configured to extend downward from the lower portion; and
the second leg is configured to extend from the first leg along the bottom.

7. The power converter according to any one of claims 1 to 6, wherein the second leg is configured to extend in a direction along the bottom, the direction being orthogonal to the first leg.

8. The power converter according to any one of claims 1 to 6, wherein
the mount of the housing further includes a fourth standing wall (251e) provided in a vicinity of an end (274a) of the second leg, the fourth standing wall being configured to come into contact with the end of the second leg when the second bus bar is fastened to the circuit board; and
the second leg is configured to extend along the bottom and extend from the first leg toward the fourth standing wall.

## Patentansprüche

1. Stromrichter (100), umfassend:
eine Leiterplatte (4), die konfiguriert ist, zu ermöglichen, dass darauf ein Stromrichterhalbleiterelement angebracht werden kann;
einen Glättungskondensator (3a);
ein Gehäuse (5), das konfiguriert ist, die Leiterplatte und den Glättungskondensator aufzunehmen;
eine erste Sammelschiene (6), die mit dem Glättungskondensator verbunden ist;
wobei der Stromrichter (100) **dadurch gekennzeichnet ist, dass** er ferner umfasst
die erste Sammelschiene (6) oberhalb der Leiterplatte (4) und des Glättungskondensators (3a),
eine zweite Sammelschiene (7, 207), die mit der Leiterplatte verbunden ist, wobei die zweite Sammelschiene über die erste Sammelschiene mit dem Glättungskondensator verbunden ist, wobei ein Abschnitt der zweiten Sammelschiene unterhalb der Leiterplatte angeordnet ist;
wobei das Gehäuse eine Halterung (51, 251) umfasst, die einen Boden (51a) umfasst, der konfiguriert ist, zu ermöglichen, dass die zweite Sammelschiene daran angebracht werden kann, und eine erste stehende Wand (51b) und eine zweite stehende Wand (51c), die beide einander zugewandt sind, sodass sie den Boden dazwischen einschließen; und
die zweite Sammelschiene einen ersten Fuß (73) umfasst, der konfiguriert ist, zu verhindern, dass die zweite Sammelschiene zu einer ersten Seite und einer zweiten Seite in einer ersten Richtung, in der die erste stehende Wand und die zweite stehende Wand einander zugewandt sind, kippt, indem sie zwischen der ersten stehenden Wand und der zweiten stehenden Wand der Halterung eingepasst ist, und einen zweiten Fuß (74, 274) umfasst, der konfiguriert ist, zu verhindern, dass die zweite Sammelschiene zu einer ersten Seite in einer zweiten Richtung orthogonal zu der ersten Richtung in einer horizontalen Ebene kippt, indem sie mit dem Boden in Kontakt kommt.

2. Stromrichter nach Anspruch 1, wobei
das Anbringen des Gehäuses eine dritte stehende Wand (51d) umfasst, die entlang der ersten Richtung vorgesehen ist, in der die erste stehende Wand und die zweite stehende Wand einander zugewandt sind; und
der erste Fuß konfiguriert ist, zu verhindern, dass die zweite Sammelschiene in der zweiten Richtung zu einer zweiten Seite kippt, indem sie in Kontakt mit der dritten stehenden Wand kommt.

3. Stromrichter nach Anspruch 2, wobei der zweite Fuß derart konfiguriert ist, dass er sich zu einer Seite erstreckt, die einer Seite entgegengesetzt ist, auf der die dritte stehende Wand der Halterung in einer Richtung entlang des Bodens angeordnet ist, sodass ein Abstand (D1) von der dritten stehenden Wand der Halterung zu einem Ende (74a, 274a) des zweiten Fußes größer ist als ein Abstand (D2) von der dritten stehenden Wand der Halterung zu einer Position (P) eines Schwerpunkts der zweiten Sammelschiene.

4. Stromrichter nach einem der Ansprüche 1 bis 3, wobei
die zweite Sammelschiene eine gestufte Form aufweist, die einen oberen Abschnitt (71) und einen unteren Abschnitt (72) umfasst;
die erste Sammelschiene an dem oberen Abschnitt der zweiten Sammelschiene befestigt ist;
die Leiterplatte an dem unteren Abschnitt der zweiten Sammelschiene befestigt ist; und
der erste Fuß und der zweite Fuß auf der Seite des unteren Abschnitts der zweiten Sammelschiene vorgesehen sind.

5. Stromrichter nach Anspruch 4, wobei der untere Abschnitt der zweiten Sammelschiene unterhalb der Leiterplatte angeordnet ist und eine Mutter (72a) zum Verschrauben des unteren Abschnitts mit der Leiterplatte integral umfasst.

6. Stromrichter nach Anspruch 4 oder 5, wobei
der erste Fuß konfiguriert ist, sich von dem unteren Abschnitt nach unten zu erstrecken; und
der zweite Fuß konfiguriert ist, sich von dem ersten Fuß entlang des Bodens zu erstrecken.

7. Stromrichter nach einem der Ansprüche 1 bis 6, wobei der zweite Fuß konfiguriert ist, sich in einer Richtung entlang des Bodens zu erstrecken, wobei die Richtung orthogonal zu dem ersten Fuß ist.

8. Stromrichter nach einem der Ansprüche 1 bis 6, wobei
die Halterung des Gehäuses ferner eine vierte stehende Wand (251e) umfasst, die in der Nähe eines Endes (274a) des zweiten Fußes vorgesehen ist, wobei die vierte stehende Wand konfiguriert ist, mit dem Ende des zweiten Fußes in Kontakt zu kommen, wenn die zweite Sammelschiene an der Leiterplatte befestigt ist; und
der zweite Fuß konfiguriert ist, sich entlang des Bodens zu erstrecken und sich von dem ersten Fuß in Richtung der vierten stehenden Wand zu erstrecken.

## Revendications

1. Convertisseur de puissance (100) comprenant :
une carte de circuit imprimé (4) configurée pour permettre à un élément semiconducteur de conversion de puissance d'être monté sur celle-ci ;
un condensateur de lissage (3a) ;
un logement (5) configuré pour loger la carte de circuit imprimé et le condensateur de lissage ;
une première barre bus (6) connectée au condensateur de lissage ; dans lequel le convertisseur de puissance (100) est **caractérisé en ce qu'**il comprend en outre
la première barre bus (6) au-dessus de la carte de circuit imprimé (4) et du condensateur de lissage (3a),
une seconde barre bus (7, 207) connectée à la carte de circuit imprimé, la seconde barre bus étant connectée au condensateur de lissage via la première barre bus, dans lequel une partie de la seconde barre bus est agencée sous la carte de circuit imprimé ;
le logement inclut un support (51, 251) incluant un fond (51a) configuré pour permettre à la seconde barre bus d'être fixé sur celui-ci, et une première paroi verticale (51 b) et une deuxième paroi verticale (51c), toutes deux se faisant face de sorte à prendre le fond en sandwich entre elles ; et
la seconde barre bus inclut un premier pied (73) configuré pour empêcher la seconde barre bus de basculer vers un premier côté et un second côté dans une première direction dans laquelle la première paroi verticale et la deuxième paroi verticale se font face en étant imbriquées entre la première paroi verticale et la deuxième paroi verticale du support, et un second pied (74, 274) configuré pour empêcher la seconde barre bus de basculer vers un premier côté dans une seconde direction orthogonale à la première direction dans un plan horizontal en venant en contact avec le fond.

2. Convertisseur de puissance selon la revendication 1, dans lequel
le support du logement inclut une troisième paroi verticale (51d) prévue le long de la première direction dans laquelle la première paroi verticale et la deuxième paroi verticale se font face ; et
le premier pied est configuré pour empêcher la seconde barre bus de basculer vers un second côté dans la seconde direction en venant en contact avec la troisième paroi verticale.

3. Convertisseur de puissance selon la revendication 2, dans lequel le second pied est configuré pour s'étendre vers le côté opposé à un côté sur lequel la troisième paroi verticale du support est agencée dans une direction le long du fond de telle sorte qu'une distance (D1) de la troisième paroi verticale du support à une extrémité (74a, 274a) du second pied est supérieure à une distance (D2) de la troisième paroi verticale du support à une position (P) d'un centre de gravité de la seconde barre bus.

4. Convertisseur de puissance selon l'une quelconque des revendications 1 à 3, dans lequel
la seconde barre bus a une forme en escalier incluant une partie supérieure (71) et une partie inférieure (72) ;
la première barre bus est fixée à la partie supérieure de la seconde barre bus ;
la carte de circuit imprimé est fixée à la partie inférieure de la seconde barre bus ; et
le premier pied et le second pied sont prévus sur le côté partie inférieure de la seconde barre bus.

5. Convertisseur de puissance selon la revendication 4, dans lequel la partie inférieure de la seconde barre bus est agencée sous la carte de circuit imprimé, et inclut d'un seul tenant un écrou (72a) pour visser la partie inférieure à la carte de circuit imprimé.

6. Convertisseur de puissance selon la revendication 4 ou 5, dans lequel
le premier pied est configuré pour s'étendre vers le bas à partir de la partie inférieure ; et
le second pied est configuré pour s'étendre à partir du premier pied le long du fond.

7. Convertisseur de puissance selon l'une quelconque des revendications 1 à 6, dans lequel le second pied est configuré pour s'étendre dans une direction le long du fond, la direction étant orthogonale au premier pied.

8. Convertisseur de puissance selon l'une quelconque des revendications 1 à 6, dans lequel
le support du logement inclut en outre une quatrième paroi verticale (251e) prévue au voisinage d'une extrémité (274a) du second pied, la quatrième paroi verticale étant configurée pour venir en contact avec l'extrémité du second pied lorsque la seconde barre bus est fixée à la carte de circuit imprimé ; et
le second pied est configuré pour s'étendre le long du fond et pour s'étendre du premier pied vers la quatrième paroi verticale.
